Europäisches Patentamt

European Patent Office

Office européen des brevets

(19)

(11) Numéro de publication: **0 109 887**
**B1**

(12) **FASCICULE DE BREVET EUROPEEN**

(45) Date de publication du fascicule du brevet:
**06.08.86**

(51) Int. Cl.⁴: **H 01 L 23/48,** H 01 L 23/56

(21) Numéro de dépôt: **83402166.9**

(22) Date de dépôt: **08.11.83**

(54) **Structure de diode hyperfréquence dont les connexions extérieures sont prises par deux poutres métalliques.**

(30) Priorité: **16.11.82 FR 8219142**

(43) Date de publication de la demande:
**30.05.84 Bulletin 84/22**

(45) Mention de la délivrance du brevet:
**06.08.86 Bulletin 86/32**

(84) Etats contractants désignés:
**DE GB NL**

(56) Documents cités:
**EP - A - 0 081 423**
**GB - A - 1 031 890**
**US - A - 4 189 342**
**US - A - 4 190 854**

(73) Titulaire: **THOMSON-CSF, 173, Boulevard Haussmann,**
**F-75379 Paris Cedex 08 (FR)**

(72) Inventeur: **Henry, Raymond, THOMSON-CSF**
**SCPI 173, bld Haussmann, F-75379 Paris Cedex 08 (FR)**

(74) Mandataire: **Taboureau, James et al, THOMSON-CSF**
**SCPI 19, avenue de Messine, F-75008 Paris (FR)**

# Description

La présente invention concerne la structure d'une diode dont les connexions externes sont prises par l'intermédiaire de poutres, cette structure étant adaptée en vue de diminuer les capacités parasites en fonctionnement dans le domaine des hyperfréquences, cependant que la robustesse de la diode est améliorée. L'invention concerne essentiellement les diodes hyperfréquences, car c'est aux fréquences très élevées qu'apparaissent les problèmes de:

— capacité parasite entre poutres métalliques,

— inductances parasites avec les connexions extérieures.

La structure selon l'invention convient pour tous les types de diodes: à jonction pn, PIN ou Schottky, mais ce sont surtout les diodes PIN et Schottky qui sont concernées.

Dans les circuits hyperfréquences, ce sont très souvent des diodes dont les connexions externes sont prises par des poutres qui sont utilisées: elles sont mieux connues sous l'appellation internationale de «Beam-Lead». Les poutres présentent moins d'inductance parasite que les fils d'or soudés, mais, comme elles reposent sur la surface de la pastille de diode, il se forme une capacité parasite entre les deux poutres, par l'intermédiaire du substrat conducteur. Il y a donc opposition entre l'obligation d'avoir une jonction de diode et des poutres petites, pour diminuer les capacités parasites, et l'obligation d'avoir des poutres de grandes sections pour minimiser les inductances parasites.

Une solution connue à ce problème consiste à faire reposer les poutres sur un anneau de verre qui entoure la pastille de diode, celle-ci étant suspendue au centre de l'anneau par les deux poutres. Cependant, cette structure s'accomode mal d'une forte dissipation de chaleur et le verre a une constante diélectrique encore trop élevée, qui fait que demeure une capacité parasite encore trop importante. US-A 4 189 342 décrit une structure de diode correspondant au préambule de la revendication 1.

Selon l'invention, les poutres ne sont plus couchées sur une même face de la pastille de diode, ce qui nécessite que la pastille soit assez grande pour constituer un support mécanique: les poutres, antiparallèles entre elles, sont fixées de part et d'autres de la pastille sur les deux faces opposées. Pour conférer plus de robustesse à l'ensemble, l'une des deux poutres est prolongée, et devient ainsi parallèle à l'autre poutre: un plot de verre réunit les deux poutres sans qu'il y ait contact latéral entre le plot de verre et la jonction de la diode. La structure comporte donc des poutres métalliques, entretoisées par une pastille de diode et par un plot de verre ou d'une manière plus générale par un plot de diélectrique.

De façon plus précise, l'invention concerne une structure de diode fonctionnant en hyperfréquences, comportant une pastille de diode dont les connexions externes sont prises par deux poutres métalliques, une première poutre étant en contact avec une première face principale de la pastille de la diode et une seconde poutre en contact avec une seconde face principale de la pastille de la diode, les deux poutres étant substantiellement parallèles entre elles et entretoisées par un plot de verre, séparé de la pastille de diode, cette structure de diode étant caractérisée en ce que la deuxième poutre est interrompue en surface du plot de verre qui porte une troisième poutre métallique, substantiellement parallèle à la première poutre, et dans le prolongement de la deuxième poutre mais en étant séparée, l'ensemble des parties métalliques et du verre du plot de verre constituant trois condensateurs de liaisons ajustables.

L'invention sera mieux comprise par la description d'exemples de structure de diode selon l'invention ainsi que par la description du procédé de fabrication de telles diodes, ces structures et le procédé étant illustrés par les figures jointes qui représentent:

figure 1: une diode beam-lead selon l'art connu

figure 2: une diode beam-lead selon l'art connu, dans une variante améliorée

figures 3 et 4: une diode beam-lead selon l'invention, vue en plan et son schéma équivalent,

figures 5 à 9: étapes de fabrication d'une diode selon l'invention,

figures 10 à 11: deux variantes à la structure d'une diode selon l'invention.

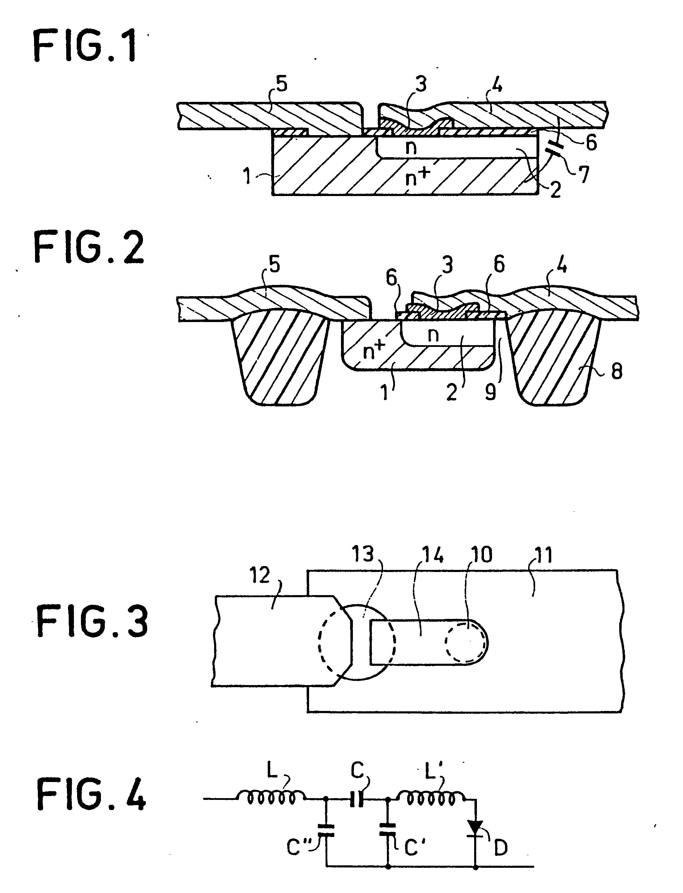

La figure 1 représente une diode beam-lead selon l'art connu. Un substrat 1, qui dans le cas de cette figure est de type $n^+$ supporte une jonction entre une couche 2 de type n et un métal donnant une barrière Schottky 3. Les prises de contact sur cette diode Schottky sont assurées par deux poutres métalliques, la poutre d'anode 4 sur le métal Schottky 3, et la poutre de cathode 5 sur le substrat $n^+$. Etant donné que ces poutres sont couchées à la surface de la pastille de diode Schottky, il est nécessaire que la poutre d'anode 4 soit isolée de la couche n 2 par l'intermédiaire d'une couche d'isolant 6, celui-ci étant fréquemment une couche de silice dopée, donc de verre, qui a une constante diélectrique plus importante que l'air.

Lorsqu'une telle diode est conçue pour travailler en hyperfréquences, et qu'elle soit de type à jonction, de type Schottky ou de type PIN, il faut que la capacité de la jonction qui constitue la diode soit petite, ce qui signifie que sa surface doit être petite. Ainsi, à titre d'exemple, à 16 GHz, le diamètre du contact Schottky est de l'ordre de 5 microns, et à 94 GHz, le diamètre de ce même contact est de l'ordre de 2 microns. Pour une diode PIN, à zone I quasi intrinsèque mince (2 à 3 microns), le diamètre de la jonction à 94 GHz est de l'ordre de 15 microns. Plus le diamètre de la jonction, projeté sur la surface libre de la pastille de diode, est petit, plus la surface de la couche d'isolant 6 devient importante et gênante du fait de la capacité parasite formée par la poutre d'anode 4 comme première armature, la couche isolante mince 6 et la couche de type n2 comme conducteur, ainsi que la poutre de cathode 5 et le substrat $n^+$ 1 comme seconde armature.

De plus, il faut minimiser l'inductance série présentée par les liaisons métalliques que sont les poutres, c'est-à-dire conserver une grande section aux poutres. La section des poutres est obtenue en particulier en réalisant des poutres plus larges qu'épaisses, ce qui conduit à une capacité parasite entre poutres, par substrat interposé, inacceptable parce qu'elle tend à court-circuiter la jonction. Sur la figure 1, le condensateur parasite 7 a été représenté par le schéma symbolique d'un condensateur entre poutres d'anode 4 couche n et substrat 1: si ce condensateur a une valeur trop élevée il court-circuite la jonction de diode. Une amélioration à la structure des diodes de façon à éviter la présence de capacités parasites est révélée dans la demande de brevet EP-A-0 081 423, publiée le 15 juin 1983, de la Demanderesse.

La figure 2 représente une vue en coupe d'une diode beam-lead selon cette demande de brevet.

La pastille de diode est également, comme sur la figure 1, constituée par un substrat 1 n$^+$ une couche 2 n et un contact Schottky 3. La poutre d'anode 4 prend le contact sur le métal Schottky 3 et la poutre de cathode 5 prend le contact sur le substrat 1. Mais, selon ce perfectionnement, la pastille de diode est limitée à une surface minimale autour de la jonction active: le support mécanique que représente la surface de la pastille pour les deux poutres beam-lead est remplacé par un anneau de verre 8 qui entoure la pastille de diode et sur lequel reposent les poutres. Ainsi, la pastille de diode est suspendue au centre de l'anneau par les deux poutres métalliques, sans qu'il y ait contact latéral entre les épaisseurs de matériaux semi condensateurs n$^+$ et n, et le condensateur parasite est limité par la faible surface de l'isolant 6 qui entoure le contact Schottky 3. Le condensateur parasite formé par la poutre d'anode 4, l'anneau de verre 8 et le substrat n$^+$ 1 a en plus une valeur fortement diminuée par la présence d'une lame d'air 9 qui sépare la pastille de diode de l'anneau de verre 8.

Bien que l'utilisation de tels caissons de verre soit très intéressante, il demeure cependant deux inconvénients:

— La constante diélectrique du verre est relativement élevée, de 6 à 12 selon les cas, et la capacité parasite peut demeurer gênante, sourtout au-delà de 30 GHz. La présence d'une capacité à air diminue la capacité parasite entre poutre 4 et substrat 1, mais, compte-tenu des dimensions extrêmement petites des diodes hyperfréquences, la lame d'air 9 est elle aussi extrêmement petite et par conséquent diminue moins la valeur de capacité parasite qu'on ne le désire.

— Ce procédé selon lequel la pastille de diode suspendue à l'intérieur d'un anneau de verre s'accomode mal d'une forte dissipation thermique, nécessaire dans certains cas avec les diodes à avalanche ou certaines diodes de commutation par exemple.

Le montage d'une pastille de diode entre une poutre conductrice et une plaque radiateur, poutre et plaque étant entretoisées par un pavé de quartz placé latéralement par rappaort à la diode, est connu du document US-A-4 189 342. Cependant, ce montage n'a pas la même finalité que la diode de la présente invention. Dans un premier cas, la diode étant fixée sur une plaque métallique qui sert de radiateur, la prise de contact sur la face supérieure de la diode est reportée latéralement, au moyen d'un ruban métallique, sur un pavé de quartz, de sorte que l'effort de compression, lors de la soudure de la connexion, s'exerce sur le pavé de quartz et non pas sur la pastille de diode, plus fragile. Dans un second cas, le bloc de quartz est remplacé par un corps annulaire en quartz qui entoure la pastille de diode, et deux rubans métalliques, soudés sur la face supérieure de la diode, reposent sur l'anneau de quartz, sur lequel est reportée la connexion: ceci constitue un moyen d'encapsulation d'une diode, la plaque radiateur fermant le cylindre de quartz à l'une de ses extrémités, et la connexion sur la face supérieure fermant le cylindre de quartz à son autre extrémité.

Dans aucun de ces deux cas, le ruban métallique reposant sur le bloc ou l'anneau de quartz n'est prolongé, au delà du bloc ou de l'anneau, par un ruban ou une poutre sensiblement anti-parallèle avec la plaque radiateur, et formant «beam-lead» séparé du ruban par une solution de continuité métallique.

La figure 3 représente une diode beam-lead selon l'invention, vue en plan, cependant que la figure 4 donne le schéma électrique équivalent de la diode selon l'invention.

Il a été dit que l'invention concerne pratiquement tous les types de diodes, qu'elles soient à jonction PN, de type Schottky ou PIN: les figures 1 et 2 représentaient des diodes Schottky, les figures 3 et suivantes représentent des diodes PIN sans que ceci n'apporte quelque limitation que se soit à la structure selon l'invention. Si la diode montée avec des poutres beam-lead selon l'invention est une diode Schottky, seules les étapes de réalisation de cette diode changent mais la structure demeure.

Selon l'invention seule la partie utile d'une diode est utilisée, ce qui signifie que tout le volume de substrat qui ne servait dans l'art connu que de support à la jonction à proprement parler, et par voie de conséquence la surface de substrat qui donne naissance à une ou plusieurs capacités parasites, est éliminé de la structure selon l'invention. On conviendra par la suite de ce texte de désigner par le repère 10 l'ensemble de la partie semiconductrice de la diode: dans le cas de la figure 3, la diode 10 est donc constituée par les trois couches PIN, mais, si la diode était de type Schottky l'ensemble 10 serait constitué par un substrat n$^+$, une couche n et une couche de métal Schottky. La diode 10 étant ainsi réduite à sa seule partie utile, une poutre d'anode 11 est connectée sur une face principale plane de la diode, une poutre de cathode 12 + 14 est connectée sur l'autre face principale de cette même diode 10, les deux faces principales étant bien entendu les deux faces planes des deux couches extrêmes. Etant donné qu'une telle structure serait fragile, car il faut tenir compte du fait que les dimensions ne se comptent qu'en microns, les deux poutres 11 et 12 sont montées sur la pastille de diode 10 antiparallèles entre elles, et l'une des deux poutres, qui est la poutre d'anode 11 dans le cas de figure, est prolongée de façon à devenir parallèle avec la poutre 12: à une certaine distance de la diode 10, les poutres 11 et 12 sont consolidées, et entretroisées entre elles par un plot de verre 13 ou d'une manière plus générale par un plot d'une substance diélectrique. Ce plot de verre permet de couper la poutre de cathode en deux parties 12 et 14, pour des raisons qui seront exposées plus loin.

A titre d'exemple, bien que ces données ne constituent nullement une limitation à la portée de l'invention, la diode de la figure 3 peut être une diode PIN au silicium à zone intrinsèque mince, d'épaisseur de l'ordre de 2 microns, pour commutation ou limitation, à des fréquences de l'ordre de 75 à 100 GHz. La pastille de silicium a un diamètre de l'ordre de 22 microns, et une épaisseur de 10 microns pour réduire la résistance série/parasite et avoir une bonne dissipation thermique. Une telle pastille de silicium équivaut à une capacité de 0,02 pF. Le plot de verre 13 a un diamètre de 70 microns, une épaisseur de 10 microns, et s'il est réalisé en une verre dont la constante diélectrique $\varepsilon = 6$, il a une capacité parasite égale à 0,02 pF. Les poutres ont une largeur de 125 microns, sauf la partie 14 assurant la liaison entre le plot de verre 13 et la pastille de silicium 10 qui a une largeur réduite à 22 microns.

Selon la figure 3, la poutre 12, dans sa partie large, est séparée de la partie étroite 14, par une interruption de la métallisation sur le plot de verre 13. Cette interruption peut être linéaire, comme cela est représenté sur la figure 3, mais elle peut également adopter d'autres formes, telles que par exemple la partie 14 se termine sur le plot de verre 13 selon un dessin semi-circulaire, tandis que la partie 12 de la poutre forme une fourche qui entoure la partie semi-circulaire de la partie 14. L'important est qu'il y a une rupture dans la métallisation de poutres entre ces deux parties 12 et 14, ce qui sur le schéma électrique de la figure 4 introduit un condensateur C, dont les deux armatures sont les deux extrémités de parties de poutres 12 et 14 et dont le diélectrique est le verre du plot 13. Puisque la poutre est scindée en deux parties 12 et 14, le condensateur C' formé par les deux poutres et le plot de verre est lui aussi scindé en deux condensateurs C' et C'', monté aux bornes du condensateur C. Le condensateur C' est formé par l'extrémité de poutre 14, le plot de verre 13, et la partie correspondante de la poutre 11. Le condensateur C'' est formé par l'extrémité de la poutre 12, le plot de verre 13, et la partie correspondante de la poutre 11.

L'intérêt de ce schéma, et donc de cette structure, est que l'on dispose d'un paramètre pour optimiser le fonctionnement de la diode. En effet, une diode est assimilable à une résistance sous polarisation directe, et pour que le rendement de la diode soit bon, il faut que cette résistance soit faible; elle est également assimilable à un condensateur sous polarisation inverse, et dans ce cas, il est important que le condensateur soit de faible valeur pour présenter une impédance élevée. Le schéma électrique de la figure 4 permet de jouer sur les caractéristiques des deux parties des poutres dont les inductances sont L et L', et sur les caractéristiques du plot de verre pour déterminer les trois capacités C, C' et C'', la poutre 11 étant considérée comme étant à la masse. On peut donc choisir le dessin des deux morceaux 12 et 14 de la poutre de cathode de façon à maîtriser les valeurs de L, L', C, C' et C'' pour avoir, sous polarisation directe en négligeant C (très élevé):
$$L'(C''+C')\omega^2 = 1$$
Dans ce cas, le composant présente une impédance très élevée à la fréquence $\omega/2\pi$, $\omega$ étant la pulsation. Sous polarisation inverse, si la capacité de la diode a pour valeur C'+C'', la diode présente une impédance très faible.

La diode de la figure 3, dont la poutre de cathode est scindée en deux morceaux, présente l'avantage qu'on peut ajuster la valeur des condensateurs parasites C, C'', C'. Par exemple en choisissant une valeur de C trop petite au cours de la réalisation de la diode, on peut l'augmenter ensuite en déposant une goutte d'un vernis ou d'un matériau diélectrique à la surface du plot de verre 13 et entre les deux extrémités de poutre 12 et 14. On peut également choisir une valeur de C trop grande, c'est-à-dire que les deux morceaux de poutre 12 et 14 sont trop proches l'un de l'autre, et diminuer la valeur de C par ajustage au laser. De la même façon, par la forme donnée aux extrémités de poutres 12 et 14, il est possible d'ajuster les valeurs C' et C'', de même qu'il est possible de les faire varier en faisant varier l'épaisseur du plot de verre comme cella sera vu plus loin, ou en modifiant la nature du diélectrique, par changement de la constante diélectrique.

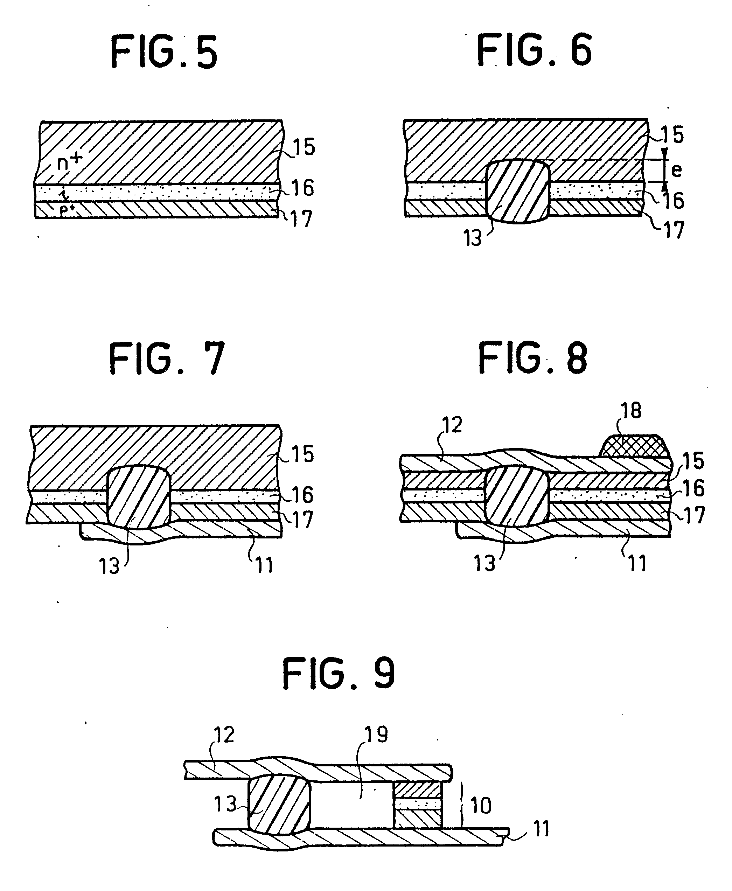

Les figures 5 à 9 représentent les différentes étapes principales de la fabrication d'une diode selon l'invention.

Ces différentes étapes concernent la fabrication d'une diode PIN, mais si la diode à fabriquer était d'un autre type tel que à jonction ou Schottky, il suffirait de modifier les étapes qui concernent la fabrication du semiconducteur à proprement parler, en remplaçant par exemple la couche de type P par un métal donnant un contact Schottky.

En figure 5, un substrat 15 de type $n^+$ est recouvert par épitaxie d'une couche 16 de résistivité maximale, et d'une couche 17, épitaxiée ou diffusée, de type $p^+$: ce sont ces trois couches qui formeront ultérieurement la diode PIN. L'ensemble est alors attaqué chimiquement à partir de la face qui supporte les deux couches épitaxiées 16 et 17, de façon à creuser un caisson, jusqu'à une profondeur «e» dans le substrat 15. La profondeut «e» de creusement dans le substrat correspond à l'épaisseur désirée pour la couche n de la diode PIN. Le caisson est alors rempli de verre en poudre, qui est ensuite fondu pour donner un plot de verre 13 comme cela est représenté en figure 6.

Sur la figure 7, la poutre inférieure 11 est réalisée par dépôt de SiPt-Ti-Pt-or, par des procédés classiques et connus tels que, la vaporisation sous vide, la photogravure, l'électrolyse. Puis l'ensemble est collé sur un support le collage ayant lieu du côté de la poutre 11 de façon à laisser dégagé le substrat 15. Celui-ci est alors aminci, par des procédés également connus tels qu'une attaque en phase aqueuse, ou sèche sous plasma, une usure mécanique ou mécanochimique. L'amincissement du substrat 15 est tel qu'il permet d'atteindre le plot de verre 13: il ne reste plus à ce moment du substrat 15 épaisseur correspondante à l'épaisseur «e» telle qu'elle a été définie au sujet de la figure 6 c'est-à-dire une épaisseur e égale à l'épaisseur de la couche $n^+$ constituant la cathode de la diode PIN.

L'étape suivante consiste à déposer sur la couche 15 une seconde métallisation 12 qui constituera la seconde poutre, la première poutre 11 ayant été préalablement déposée sur l'autre face du dispositif. Cette métallisation 12 peut être déposée par différents procédés connus de l'homme de l'art, tels qu'une métallisation générale suivie d'une gravure, ou une métallisation localisée qui donne directement une poutre 12. Puis un bouton de résine de masquage 18 est déposé à l'emplacement où l'on désire obtenir une diode montée entre les deux poutres 11 et 12. Si l'on se réfère aux figures précédentes, et en particulier à la figure 4, il est évident qu'il est préférable de déposer le bouton de masquage 18 sur la poutre qui est affinée, c'est-à-dire sur la poutre 12, la poutre 11 plus large servant à la fois d'embase et de radiateur à la diode 10.

Lorsque la position de la diode a été déterminée, on élimine les couches semiconductrices, c'est-à-dire dans le cas décrit à titre d'exemple les couches de silicium 15, 16 et 17, dans les zones situées à l'extérieur des poutres, et autour de la future diode 10, par attaque chimique par exemple. Il y a intérêt à réaliser cette élimination en deux étapes, la première étape correspondant à celle où il faut éliminer le maximum de matériau semiconducteur et en particulier entre les deux poutres, dans la zone de sous gravure 19 telle qu'elle est représentée en figure 9. Cette première étape est peu précise, et élimine le plus gros du matériau semiconducteur. Dans une seconde étape, l'attaque chimique est plus précise et elle découpe litéralement la diode 10, de même qu'elle achève d'éliminer le matériau semiconducteur qui aurait pu rester en sous gravure dans la région 19 entre les deux poutres. Lorsque cette opération de gravure est terminée, il ne reste plus qu'à passiver par de la silice dopée à basse température, c'est-à-dire à une température inférieure ou égale à 450°C, les flancs de la pastille de la diode. La figure 9 représente donc une diode PIN 10 comprise entre une première poutre 11 qui s'appuie sur une première face de la diode, et une seconde poutre 12 qui s'appuie sur une seconde face de la diode, les deux poutres 11 et 12 étant entretoisées par un plot de verre 13.

La poutre 12, qui est amincie dans sa partie 14 (voir figure 3) parce qu'elle n'assure pas comme la poutre 11 une fonction d'embase et de radiateur de la diode, peut rester monolithique, telle que représentée sur la figure 9. Cependant, selon l'invention, il est préférable de la diviser en deux parties 12 et 14, telles que représentées sur les figures 3, 10 et 11, puisque cela introduit une capacité de réglage C. Le procédé de fabrication d'une diode selon l'invention comporte donc une étape supplémentaire: l'entaille entre les parties 12 et 14 de la poutre peut être faite par masquage approprié avant de realiser le dépôt de la couche 12 en figure 8, soit par un passage laser sur la diode de la figure 9.

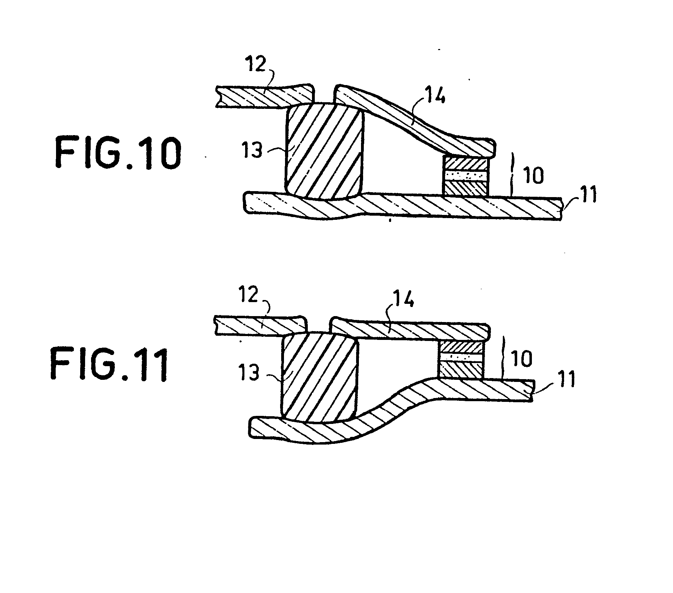

Les figures 10 et 11 représentent deux variantes à la structure d'une diode selon l'invention. Alors que dans les figures des étapes de réalisation, de 5 à 9, la poutre 12 était représentée monolithique, les figures 10 et 11 reprennent le cas de la figure 3 selon lequel la poutre 12 peut être scindée en deux parties présentant entre elles une liaison capacitive par un condensateur C.

En vue de réaliser un plot de verre plus épais, qui donnera donc des capacités parasites C' et C'' (cf fig. 4) de plus petites valeurs puisque le diélectrique est plus épais, on se trouve alors dans le cas d'une diode 10 d'une certaine épaisseur, et d'un plot 13 qui a une épaisseur différente et généralement supérieure puisque l'épaisseur de la diode 10 est de l'ordre de 10 microns. Dans ce cas là, la poutre 11 étant considérée comme référence de base, la liaison entre le plot de verre 13 et la pastille de diode 10 qui est moins haute que le plot de verre 13 se fait par l'intermédiaire d'un ruban ou d'un fil métallique 14. C'est ce qui est représenté sur la figure 10. En figure 11, le cas inverse a été pris, et c'est la poutre de cathode 12 et 14 qui reste plane cependant que la poutre d'anode 11 est déviée pour récupérer la différence d'épaisseur entre la diode 10 et le plot de verre 13. Cependant, cette réalisation est moins aisée à mettre en oeuvre, étant donné que la poutre 11 doit à ce moment là être thermosoudée sur le plot de verre et sur la pastille de diode, puisqu'il n'est plus possible de l'obtenir directement par métallisation d'une rondelle de silicium comme cela a été représenté sur la figure 7.

De toute façon la liaison électrique entre le plot de verre 13 et la pastille de diode 10 peut également se faire par thermo-compression d'un fil ou d'un ruban d'or au lieu de la portion de poutre 14: bien qu'un fil amène une inductance parasite plus élevée aux fréquences considérées, les dimensions de la diode et de sa liaison 14 sont si petites que l'inductance d'un fil qui n'a que quelques dizaines de microns de longueur est acceptable dans le fonctionnement de la diode selon l'invention.

L'invention a été décrite en s'appuyant sur le cas d'une diode PIN en silicium, mais cette précision, qui n'avait pour but que de clarifier l'exposé, ne limite absolument pas l'invention qui concerne les diodes de façon générale, qu'elles soient en silicium ou en matériau des familles III-V tel que GaAs par exemple, et quelque soit la structure de la diode. L'important est, étant donné que ce sont les hautes fréquences jusque 100 GHz ou plus qui sont considérées, que les poutres présentent le moins possible de capacité parasite entre elles ou avec le substrat de la diode. La diode étant selon l'invention limitée à sa seule partie active et utile du point de vue du fonctionnement, toutes les parties ayant un rôle mécanique étant éliminées, elle ne présente plus comme capacité parasite entre les poutres que la ou les faibles capacités représentées par les poutres et le plot de verre.

L'invention est précisée par les revendications suivantes.

**Revendications**

1. Structure de diode fonctionnant en hyperfréquences, comportant une pastille de diode (10) dont les connexions externes sont prises par deux poutres métalliques (11, 14), une première poutre (11) étant en contact avec une première face principale de la pastille de la diode (10) et une seconde poutre (14) en contact avec une seconde face principale de la pastille de la diode (10), les deux poutres (11, 14) étant substantiellement parallèles entre elles et entretoisées par un plot de verre (13), séparé de la pastille de diode (10), cette structure de diode étant caractérisée en ce que la deuxième poutre (14) est interrompue en surface du plot de verre (13) qui porte une troisième poutre métallique (12), substantiellement parallèle à la première poutre (11), et dans le prolongement de la deuxième poutre (14) mais en étant séparée, l'ensemble des parties métalliques (11, 12, 14) et du verre du plot de verre (13) constituant trois condensateurs de liaisons ajustables (C, C', C'').

2. Structure de diode selon la revendication 1, caractérisée en ce que, le plot de verre (13) ayant même épaisseur que la pastille de diode (10), les trois poutres (11, 12, 14) sont planes et parallèles entre elles.

3. Structure de diode selon la revendication 1, caractérisée en ce que, le plot de verre (13) ayant une épaisseur différente de l'épaisseur de la pastille de diote (10), au moins deux poutres sont planes (11, 12) tandis qu'une poutre (14), courbée, corrige la différence de hauteur entre plot de verre (13) et pastille de diode (10).

4. Procédé d'ajustage d'une diode ayant une structure selon la revendication 1, caractérisé en ce que, dans le cas où le condensateur ajustable (C) formé par les deux parties de poutres (12, 14), portées par une même face du plot de verre (13), a une valeur trop élevée, il est ajustable par abrasion de métal, au moyen d'un laser.

5. Procédé d'ajustage d'une diode ayant une structure selon la revendication 1, caractérisé en ce que, dans le cas où le condensateur ajustable (C) formé par les deux parties de poutres (12, 14), portées par une même face du plot de verre (13), a une valeur trop faible, il est ajustable par dépôt d'un vernis diélectrique entre les deux parties de poutres (12, 14), sur le plot de verre.

6. Procédé d'ajustage d'une diode ayant une structure selon la revendication 1, caractérisé en ce que, en vue d'optimiser le fonctionnement de la diode (10) aux fréquences de travail, la hauteur du plot de verre (13), sa section, la constante diélectrique ($\varepsilon$) du verre et les surfaces de poutres (12, 14) en contact avec le plot de verre (13) sont choisies pour minimiser les condensateurs parasites.

**Patentansprüche**

1. Struktur einer Mikrowellendiode mit einem Diodenplättchen (10), dessen Aussenanschlüsse von zwei metallischen Balken (11, 14) gefasst sind, von denen ein erster Balken (11) mit einer ersten Hauptseite des Diodenplättchens (10) und ein zweiter Balken (14) mit einer zweiten Hauptseite des Diodenplättchens (10) in Berührung steht, wobei die beiden Balken (11, 14) im wesentlichen zueinander parallel verlaufen und von einem Glastropfen (13) in Abstand von dem Diodenplättchen (10) abgestützt werden, dadurch gekennzeichnet, dass der zweite Balken (14) an der Oberfläche des Glastropfens (13) unterbrochen ist, dass der Glastropfen einen dritten metallischen Balken (12) trägt, der sich im wesentlichen parallel zum ersten Balken und in der Verlängerung des zweiten Balkens (14), aber von diesem getrennt erstreckt, wobei die Gesamtheit der Metallteile (11, 12, 14) und des Glastropfens (13) drei einstellbare Verbindungskondensatoren (C, C', C'') bildet.

2. Diodenstruktur nach Anspruch 1, dadurch gekennzeichnet, dass der Glastropfen (13) dieselbe Dicke wie das Diodenplättchen (10) besitzt, so dass die drei Balken (11, 12, 14) eben und zueinander parallel sind.

3. Diodenstruktur nach Anspruch 1, dadurch gekennzeichnet, dass die Dicke des Glastropfens (13) sich von der des Diodenplättchens (10) unterscheidet und dass mindestens zwei Balken (11, 12) eben sind, während ein gekrümmter Balken (14) den Höhenunterschied zwischen dem Glastropfen (13) und dem Diodenplättchen (10) ausgleicht.

4. Verfahren zum Trimmen einer Diode, die eine Struktur nach Anspruch 1 besitzt, dadurch gekennzeichnet, dass der einstellbare Kondensator (C), der von den beiden auf derselben Seite des Glastropfens liegenden Balken (12, 14) gebildet wird, durch Abschneiden von Metall mit Hilfe eines Lasers eingestellt wird, falls dieser Kondensator eine zu grosse Kapazität besitzt.

5. Verfahren zum Trimmen einer Diode, die eine Struktur nach Anspruch 1 besitzt, dadurch gekennzeichnet, dass der einstellbare Kondensator (C), der von den beiden auf derselben Seite des Glastropfens (13) liegenden Balken (12, 14) durch Aufbringen eines dielektrischen Lacks auf den Glastropfen zwischen die beiden Balkenbereiche (12, 14) eingestellt wird, falls dieser Kondensator (C) eine zu kleine Kapazität besitzt.

6. Verfahren zum Trimmen einer Diode, die eine Struktur nach Anspruch 1 besitzt, dadurch gekennzeichnet, dass in Hinblick auf einen optimalen Betrieb der Diode (10) bei den Arbeitsfrequenzen die Höhe des Glastropfens (13), sein Querschnitt, die Dielektrizitätskonstante ($\varepsilon$) des Glases und die Oberflächen der Balken in Kontakt mit dem Glastropfen (13) so gewählt sind, dass die Störkapazitäten möglichst klein werden.

**Claims**

1. A diode structure for microwave frequency operation, comprising a diode dice (10), whose external connections are taken by two metal beams (11, 14), a first beam (11) being in contact with a first principal face of the diode dice (10) and a second beam (14) being in contact with a second principal face of the diode dice (10), the two beams (11, 14) being substantially parallel to each other and spaced apart by a glass stud (13), separate from the diode dice (10), characterized in that the second beam (14) is interrupted, on the surface of the glass stud (13) which bears a third metal beam (12), substantially parallel to the first beam (11) and aligned with the second beam (14) but separated therefrom, the assembly of the metal parts (11, 12, 14) and of the glass stud (13) forming three adjustable coupling capacitors (C, C', C'').

2. A diode structure as claimed in claim 1, characterized in that the glass stud (13) having the same thickness as the diode dice (10), the three beams (11, 12, 14) are flat and parallel to each other.

3. A diode structure as claimed in claim 1, characterized in that the glass stud (13) having a thickness different from the thickness of the diode dice (10), at least two beams (11, 12) are flat, whereas one beam (14), which is curved, corrects the difference in height between the glass stud (13) and the diode dice (10).

4. A method for adjusting a diode having a structure as claimed in claim 1, characterized in that, in the case where the adjustable capacitor (C) formed by the two beam portions (12, 14) which are applied to the same face of the glass stud (13) has too high a value, it may be adjusted by metal abrasion by means of a laser.

5. A method for adjusting a diode having a structure as claimed in claim 1, characterized in that in the case where the adjustable capacitor (C) formed by the two beam portions (12, 14) applied to the same face of the glass stud (13) has too low a value, it may be adjusted by depositing a dielectric varnish between the two beam portions (12, 14) on the glass stud.

6. A method for adjusting a diode having a structure as claimed in claim 1, characterized in that for optimizing the operation of the diode (10) at working frequencies, the height of the glass stud (13), its section, the dielectric constant ($\varepsilon$) of the glass and the beam (12, 14) surfaces in contact with the glass stud (13) are chosen so as to minimize parasite capacitors.

**FIG.1**

**FIG.2**

**FIG.3**

**FIG.4**

# FIG. 5

n+

P⁺

15
16
17

# FIG. 6

15
e
16
17

13

# FIG. 7

15
16
17

13    11

# FIG. 8

12        18

15
16
17

13        11

# FIG. 9

12        19

13        10

11

FIG.10

FIG.11